# NEUE EUROPÄISCHE PATENTSCHRIFT

(11) **EP 0 158 027 B2**
(45) Veröffentlichungstag und Bekanntmachung des Hinweises auf die Entscheidung über den Einspruch: **02.05.1997**
(45) Hinweis auf die Patenterteilung: 13.06.1990
(21) Anmeldenummer: 85101282.3
(22) Anmeldetag: 07.02.1985
(51) Int. Cl.: B32B 15/14, B32B 31/08, H05K 3/02

(54) **Verfahren zum Herstellen von kupferkaschiertem Basismaterial für Leiterplatten**
Method for making copper-clad base material for conductive plates
Procédé de fabrication de matériau de base, revêtu de cuivre, pour plaques conductrices

(30) Priorität: 10.04.1984 DE 3413434
(43) Veröffentlichungstag der Anmeldung: 16.10.1985
(73) Patentinhaber: DIELEKTRA GmbH, 51145 Köln (DE)
(72) Erfinder: Schwarz, Lothar, D-5253 Lindlar (DE); Ueberberg, Friedel, D-5253 Lindlar (DE); Kühne, Rudolf, D-5000 Köln 90 (DE); Fischer, Dieter, D-5000 Köln 90 (DE)
(74) Vertreter: Blumbach, Kramer & Partner

(56) Entgegenhaltungen:
- EP-A- 0 012 094
- EP-A- 0 036 635
- EP-A- 0 058 045
- EP-A- 0 120 192
- AT-B- 316 116
- DD-A- 83 645
- DE-A- 2 648 088
- DE-A- 2 722 262
- DE-A- 2 937 410
- DE-A- 3 307 057
- DE-B- 1 084 014
- DE-B- 2 722 262
- DE-C- 1 216 522
- FR-A- 2 248 929
- GB-A- 754 935
- GB-A- 1 057 783
- GB-A- 2 108 427
- JP-A- 45 997
- JP-A- 45 998
- US-A- 2 135 763
- US-A- 3 208 894
- US-A- 3 298 887
- US-A- 3 523 037
- US-A- 3 699 202
- US-A- 3 801 407
- US-A- 4 336 096
- US-A- 4 420 509
- IBM TECHNICAL DISCLOSURE BULLETIN, Band 10, Nr. 1, Juni 1967, Seite 12, New York, US; T.L. ELLIS: "Lamination process"
- Broschüre "Doppelbandanlage für kupferkaschierte Elektrolaminate" der Firma Kurt Held GmbH vom 05.10.83
- Kunststoffe Bd. 62, 1972, H. 6, S. 355-359, Kurt Borchard "Gedruckte Schaltungen"
- Holz- und Kunststoffverarbeitung 11/82, S. 996-1000, "Doppelbandpressen der zweiten Generation"
- J. Appl. Polym. Sci. 12 (1968), S. 159-168, A. Farkas, P.F. Ströhm: "Imidazole Catalysis in the Curing of Epoxy Resins"
- Kunststoff-Handbuch, Band I, Grundlagen, 1975, S. 121-124
- H. Jahn. "Epoxidharze", 1969
- Domininghaus: "Die Kunststoffe und ihre Eigenschaften", 1976, S. 491-492
- P.M. Craven: "Prepreg and Flow in Multilayer Laminates" in International Printed Circuits Exhibition/Conference 19.-21.06.1979

## Beschreibung

Die Erfindung betrifft ein Verfahren zum Herstellen von metallkaschiertem Basismaterial für Leiterplatten der im Oberbegriff des Anspruchs 1 angegebenen Gattung sowie eine Doppelbandpresse zur Durchführung eines solchen Verfahrens der im Oberbegriff des Anspruchs 13 angegebenen Gattung. Ein derartiges Verfahren und eine derartige Doppelbandpresse sind aus der EP―A―0 120 192 bekannt.

Metallkaschierte Basismaterialien für Leiterplatten werden bisher ausschließlich diskontinuierlich durch Verpressen von zugeschnittenen, mit wärmehärtbarem Harz versehenen Schichtstoffen und Metallfolien in Etagenpressen hergestellt. Ein solches Verfahren ist aufwendig und liefert Basismaterialien mit innerhalb der Einzelplatte variierender Qualität. Deshalb bestand schon seit langem der Wunsch nach einem kontinuierlichen Verfahren.

Einen Schritt in Richtung Kontinuität zeigt das gattungsgemäße Verfahren nach der GB―A―2 108 427, bei dem mit einem wärmehärtbaren Harz versehene Glasfasergewebebahnen, die zur Vermeidung einer unerwünschten Vorreaktion des Harzes vor dem Verpressen gekühlt werden, und die aufzukaschierende Metallfolie in einer Preßeinrichtung unter Druck und Temperatur miteinander verpreßt werden und das so erhaltene Basismaterial abgelängt wird. Das Verpressen erfolgt jedoch intermittierend in der Weise, daß die in die Presse eingeführte Glasfasergewebebahn und die Kupferfolie jeweils während des Preßvorgangs stillstehen und das verpreßte Endprodukt taktweise ausgestoßen wird. Die so hergestellte Leiterplatte besteht deshalb aus Einzelabschnitten, deren Abmessungen durch jene der Heizplatten begrenzt sind und die untereinander durch nicht verpreßte, d.h., unbrauchbare, Abschnitte miteinander verbunden sind. Auch hier kommt es jedoch zu starken Qualitätsschwankungen innerhalb einer Einzelplatte, was bei den Forderungen der Abnehmer nach hoher, homogener Qualität der Leiterplatten zu großen Mengen an Ausschuß führt.

Aus der EP―B1―0 036 635 ist eine Vorrichtung zum Zusammenfügen mehrerer bandförmiger Werkstoffschichten zu einer Verbundfolie bekannt, die eine Doppelbandpresse mit umlaufenden, beheizbaren Stahlbändern aufweist. An der Einlaufseite der Doppelbandpresse ist jedem Stahlband ein als Wärmedämmung dienender Schutzschild zugeordnet. Durch die beiden Schutzschilder wird ein Aufheizen der Werkstoffschichten über Raumtemperatur vermieden. Doppelbandpressen der vorgenannten Art sind aus der Herstellung dekorativer Schichtstoffe bekannt.

Aus der DE―C―1 216 522 ist ein Verfahren zum Herstellen von plattenförmigem Material aus Kunststoff, insbesondere zu Behandlung der Oberflächen von Platten aus Holz, Sperrholz, Preßspan und dergleichen, bekannt, wobei als bevorzugte Ausgangsmaterialien für die Deckschichten kunstharz-, insbesondere melaminharz-imprägnierte Papiere verwendet werden. Nach einer beiläufig angesprochenen Variante soll als oberste und unterste Schicht auch ein Blech, z.B. aus Kupfer, verwendbar sein, das vorher in der zur Bildung eines bestimmten Musters für eine gedruckte Schaltung erforderlichen Weise gestanzt wurde. Anstelle der vorerwähnten Platten aus Holz und dergleichen können für die Innenschicht dann auch phenolharz-imprägniertes Papier oder epoxidharz-imprägnierte Glasfasergewebe verwendet werden.

Der Erfindung liegt die Aufgabe zugrunde, ein Verfahren zum Herstellen von metallkaschiertem Basismaterial für Leiterplatten der angegebenen Gattung zu schaffen, das kontinuierlich ausgeführt werden kann, und zudem zu einem Material hoher, homogener Qualität und insbesondere hoher Maßhaltigkeit führt.

Diese Aufgabe wird erfindungsgemäß durch die im kennzeichnenden Teil des Anspruchs 1 angegebenen Merkmale gelöst.

Zweckmäßige Ausführungsformen werden durch die Merkmale der Unteransprüche 2 bis 12 definiert.

Nach einem anderen Aspekt liegt der Erfindung die Aufgabe zugrunde, eine Doppelbandpresse zur Durchführung eines solchen Verfahrens zu schaffen, die kontinuierlich die Ausgangsmaterialien, nämlich die Glasfasergewebebahnen einerseits und die aufzukaschierende Metallfolie andererseits, aufnimmt und zu einem metallkaschiertem Basismaterial für Leiterplatten hoher homogener Qualität und insbesondere hoher Maßhaltigkeit verarbeitet.

Diese Aufgabe wird erfindungsgemäß durch die im kennzeichnenden Teil des Anspruchs 13 angegebenen Merkmale gelöst.

Zweckmäßige Ausführungsformen dieser Doppelbandpresse werden durch die Merkmale der Ansprüche 14 bis 18 definiert.

Die mit der Erfindung erzielten Vorteile beruhen auf einer gezielten Kombination von Maßnahmen, die insgesamt zu optimalen Produkten führen.

Gemäß einem der kennzeichenden Merkmale wird erfindungsgemäß ein beschleunigtes Harzsystem verwendet. Dies ist eine der Voraussetzungen für die Erzielung optimaler Ergebnisse. Bevorzugt sind dabei beschleunigte Epoxidharz-Systeme, also beschleunigte, wärmehärtbare Epoxid-Härter-Katalysator-Système.

Als Beschleuniger sind unter anderem folgende Pyridinverbindungen geeignet:
2-Benzoylpyridin,
3-Benzoylpyridin,
4-Benzoylpyridin,
2-Benzylpyridin,
3-Benzylpyridin,
4-Benzylpyridin,
2-Benzylaminopyridin
4-Dimethylaminopyridin
2-Methoxypyridin
4-tert.-Butylpyridin
3-Cyanpyridin
2-Hydroxypyridin
6-Amino-2-pyridin
2-Aminopyridin
3-Aethylpyridin
3-Aethyl-4-Methylpyridin
2-Phenylpyridin
2,6-Diaminopyridin
3-Methylpyridin
2-(Aminomethyl)-pyridin
2-Amino-4-methylpyridin
2,4-Dimethylpyridin

Eine zweite vorteilhafte Gruppe von Beschleunigern sind die an sich bekannten substituierten Imidazol-Verbindungen einschließlich des Imidazols selbst, und zwar:
N-Methylimidazol
2-Methylimidazol
2-Phenylimidazol
4-Phenylimidazol
4-Methylimidazol
2-Methylbenzimidazol
5,6-Dimethylbenzimidazol
1-Methyl-2-phenylbenzimidazol
1,2-Dimethylimidazol
4,5-Diphenylimidazol
2-Aethyl-4-Methylimidazol
Carbonyldiimidazol
Imidazol
2-Undecylimidazol
1-Cyanoäthyl-2-phenylimidazol
2-Phenylbenzimidazol.

Besonders gute Resultate werden mit einer Kombination von Dicyandiamid bzw. Benzyldimethylamin mit den obengenannten Pyridinen bzw. Imidazolen erzielt. Dabei wird erfindungsgemäß allgemein eine stärkere Beschleunigung als bei bekannten Harzsystemen angestrebt, vor allem um in der Presse eine wirtschaftliche Durchlaufgeschwindigkeit zu erzielen.

Ein weiteres Merkmal besteht in der Verwendung eines vorgehärteten Harzes. Besonders bewährt haben sich harzimprägnierte Bahnen, in denen das Harz bis zum B-Zustand vorgehärtet ist. Dabei wird vorzugsweise ein fortgeschrittenerer B-Zustand, d.h. mit einem geringeren Harzfluß, als beim Vorhärten für das Etagepressen angestrebt.

Ein ganz wesentliches Merkmal ist die drucklose Vorerwärmung der mit dem beschleunigten Harz imprägnierten Gewebebahnen.

Daß das druckfreie Vorwärmen der mit dem wärmehärtbaren Harz-System versehenen Glasfasergewebebahnen die Benützung einer geeigneten Doppelbandpresse und damit die kontinuierliche Herstellung einer qualitativ einwandfreien metallkaschierten Basismaterialbahn ermöglicht, ist außerordentlich überraschend, zumal wenn man bedenkt, daß ein gehärtetes, d.h. ausreagiertes, Harz inert ist und keine Bindung mehr eingeht und daß durch das Vorwärmen der Glasfaserbahnen die Härtungsreaktion des beschleunigten, bereits vorgehärteten Harz-Systems weiter vorangetrieben wird. Die Größe der Überraschung für die Fachwelt tritt im Lichte der eingangs genannten GB―A―2 108 427 und EP―B1 0 036 635 und des daraus ersichtlichen Vorurteils der Fachwelt besonders deutlich hervor. Denn nach Auffassung der Fachwelt war zur Vermeidung einer unerwünschten Vorreaktion das Harz nach dem Aufbringen und vor der Presse zu kühlen, d.h. die ganz Reaktionskapazität des Harzes für die Herstellung der Bindung zwischen den einzelnen Schichten während des Preßvorgangs zu reservieren. Wenn man sich nun vor Augen hält, daß diese Empfehlung für ein normal härtendes, d.h. nicht beschleunigtes, und nicht vorgehärtetes Harz gegeben wird, erscheint die erfindungsgemäße Maßnahme des Vorwärmens eines Harzes, das durch Vorhärten einen Teil seiner Reaktionskapazität bereits eingebüßt hat und dessen Reaktionskapazität infolge der Beschleunigung beim Erwärmen beschleunigt schwindet, als barer Unsinn. Diese der Empfehlung des Standes der Technik diametral widersprechende Maßnahme des Vorwärmens ermöglicht aber gerade die kontinuierliche Herstellung von metallkaschiertem Basismaterial für Leiterplatten. Offensichtlich erfolgt durch die mittels Vorwärmen des beschleunigten und vorgehärteten Harzes verursachte Vorreaktion eine Aktivierung des Harzes für die nachfolgende Reaktion unter Druck, so daß in der Presse selbst ein schlagartig einsetzendes Verbinden stattfindet.

Zur Durchführung des Verfahrens werden die imprägnierten Glasfasergewebebahnen vor dem Einlaufen in die Doppelbandpresse zusammengebracht und unter Viskositäts-Verringerung des Harz-Systems unabhängig von den Metallfolien drucklos vorgewärmt, während die Metallfolien in diesem Bereich also noch nicht mit den Glasfaserbahnen verbunden sind und räumlich und physikalisch von ihnen getrennt geführt werden. In Transportrichtung gesehen erfolgt erst hinter dieser drucklosen Vorwärmzone das Zusammenführen bzw. Verbinden der vorgewärmten Glasfasergewebebahnen und der Metallfolien. Bei erhöhter Temperatur sowie unter Druck werden dann beide miteinander verpreßt.

Die drucklose Vorwärmung der imprägnierten Glasfasergewebebahnen führt zu einer Viskositätserniedrigung des wärmehärtbaren Harzes, wodurch das Harz der einzelnen, sich berührenden Glasfasergewebebahnen in innige Berührung zueinander gebracht wird und beim anschließenden Einsetzen des Preßdrucks keine Grenzflächen zwischen den Glasfasergewebebahnen bzw. ihren Harzschichten mehr überwunden werden müssen. Außerdem führt die von der Vorwärmung des beschleunigten und vorgehärteten Harzes verursachte Vorreaktion zu einer Aktivierung des Harzes für die nachfolgende Druckreaktion, so daß in der Doppelbandpresse selbst die Metallfolien einerseits und die harzimprägnierten Glasfasergewebebahnen andererseits schlagartig miteinander verbunden werden.

Die angesprochene, in der drucklosen Vorwärmzone auftretende Viskositätserniedrigung des Harzes ermöglicht auch das Austreten von eingeschlossenen Luftbläschen aus den Harzschichten, die sich sonst zu größeren Luftblasen ansammeln und die angestrebte, homogene Qualität des Basismaterials behindern können.

Durch das erfindungsgemäße kontinuierliche Verfahren werden die bei einem diskontinuierlichen oder beim oben beschriebenen Taktverfahren beobachteten Unterschiede zwischen minderwertigeren Randbereichen und hochwertigerer Mittelpartie der einzelnen Platten eliminiert, so daß das erhaltene Basismaterial eine gleichmäßig hohe Qualität aufweist und zu Platten homogener Qualität abgelängt werden kann.

Doppelbandpressen, die in Verbindung mit der drucklosen Vorwärmzone eingesetzt werden können, sind beispielsweise in der EP―A―0 026 396 und EP―A―0 026 401 soule in der US―A―4 336 096 beschrieben.

Das Harz-System der Glasfasergewebebahnen ist, wenn letztere vor der Vorwärmzone der Doppelbandpresse zusammengeführt werden wie schon erwähnt, bereits vorgehärtet, und zwar im allgemeinen bis zum B-Zustand. Dabei wird vorzugsweise ein fortgeschrittener B-Zustand, d.h. mit einem geringeren Harzfluß als beim Vorhärten für das Etagenpressen, angestrebt. Dieses mehrschichtige Gebilde wird in der der druckwirksamen Zone vorgeordneten, drucklosen Vorwärmzone im allgemeinen gleichmäßig erwärmt. Durch die Viskositätserniedrigung, bei der das Harz weich und plastisch wird, findet ein Ausgleich von eventuell bestehenden Unebenheiten und eine innige Berührung der Schichten bereits hier statt. Die Vorwärmtemperatur ist abhängig vom Harz-System; vorzugsweise beträgt sie ca. 80° bis 100°C. Aus der drucklosen Vorwärmzone gelangt das mehrschichtige Gebilde etwa mit 100°C in die druckwirksame Zone, wobei es unmittelbar vorher mit einer oder zwei, vorzugsweise getrennt vorgewärmten, Metallfolien zusammengebracht und bei einer vorteilhaft ansteigenden Temperatur von 150° bis 210°C mit 25 bis 80 bar verpreßt wird. Das nun aus mehreren Schichten gebildete Basismaterial wird anschließend, vorzugsweise unter Druck, insbesondere unter Aufrechterhaltung des Verpreßdruckes, vorteilhaft unter den Glasumwandlungspunkt des Harzes, abgekühlt, gegebenenfalls weiter getempert und abgelängt. Die Abkühlung unter Druck, d.h. in der Presse, dient zur Stabilisierung der durch das kontinuierliche Verfahren erzielten hohen Qualität des Basismaterials, insbesondere zur Vermeidung einer Verformung.

Als weitere wesentliche Vorteile des erfindungsgemäßen Verfahrens sind anzusehen:
― die optimale Ausnützung bei der Zuschnittanfertigung, da die kontinuierliche Bahn beliebig abgelängt werden kann:
― die Materialersparnis, da nur eine zweiseitige Basäumung notwendig ist;
― die Energieersparnis, da der Kühlvorgang und damit die Energievernichtung beim Etagenpreßverfahren entfällt;
― eine qualitative Verbesserung des Laminats, insbesondere der Dimensionsstabilität;
― Verminderung des Ausschusses durch sauberer zu haltende Metallfolienoberfläche.

Gegenüber den diskontinuierlichen Herstellungsverfahren in sogenannten Etagenpressen ergibt sich eine wesentliche Einsparung an Arbeitsgängen, und zwar das Querschneiden der Prepregs auf Formatlänge, das Querschneiden der Cu-Folien auf Formatlänge, das Vorverlegen der Prepregpakete, der Aufbau der Laminatpakete, das Vereinzeln der Laminatpakete, der Wegfall der kostspieligen Preßbleche und der Wegfall des nur einmal einsetzbaren Polsterpapiers.

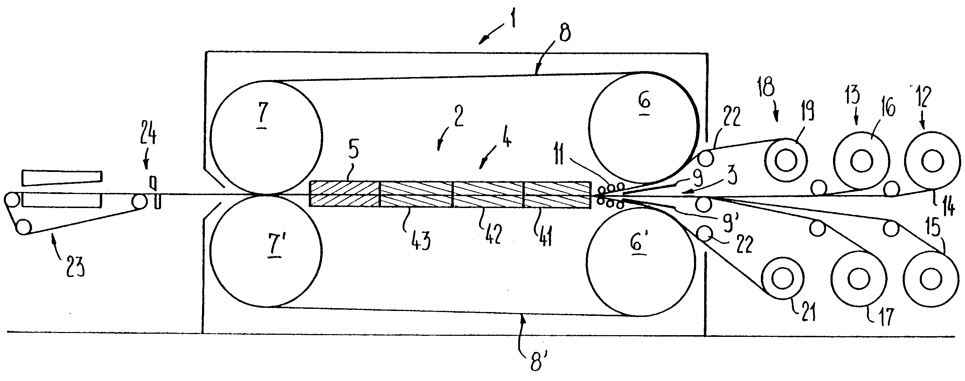

Anhand des in der beiliegenden Zeichnung dargestellten Ausführungsbeispiels einer zur Durchführung des erfindungsgemäßen Verfahrens geeigneten Vorrichtung wird die Erfindung nunmehr näher erläutert.

Die in der Figur dargestellte Vorrichtung weist eine Doppelbandpresse 1 mit einer druckwirksamen Zone 2 und dieser vorgeordnet einerdruckfreien Vorwärmzone 3 auf. Die druckwirksame Zone 2 ist in einen längeren, an die Vorwärmzone 3 anschließenden Heizbereich 4 und einen auf den Heizbereich folgenden, kürzeren Kühlbereich 5 unterteilt. Der Heizbereich 4 seinerseits weist drei voneinander unabhängig steuerbare Temperaturbereiche 41, 42, 43 auf. Die Doppelbandpresse 1 weist vor der druckwirksamen Zone 2 ein in größerem Abstand zueinander angeordnetes beheiztes Einzugs-Umlenktrommelpaar 6, 6', nach der druckwirksamen Zone 2 ein entsprechend ausgestaltetes in kleinerem Abstand zueinander angeordnetes Auszugs-Umlenktrommelpaar 7, 7' und im Anschluss an das Einzugs-Umlenkrollenpaar Stützrollen 11, 11' für die Druckbänder 8, 8' der Doppelbandpresse 1 auf. Zur Konstanthaltung der Temperatur ist die Vorwärmzone 3 gegenüber den durch die Einzugs-Umlenktrommeln 6 erwärmten Druckbändern 8 der Doppelbandpresse 1 mit einem Hitzeschildpaar 9, 9' abgegrenzt. Letzteres besteht aus einem gekühlten Blech. Als Kühlung dienen Kühlschlangen, hier aus Kupfer, in denen die Durchflußgeschwindigkeit des Kühlmittels gesteuert werden kann, so daß eine genaue Temperatursteuerung möglich ist. Anstatt der Kühlschlangen können auch Kühltaschen mit Zwangsführung vorgesehen werden. Die Hitzeschilder 9, 9' sind in horizontaler Richtung verschiebbar angeordnet, so daß die temperaturgesteuerte Vorwärmzone der druckwirksamen Zone 2 angenähert oder davon entfernt werden kann, d.h. auch bezüglich ihrer räumlichen Anordnung gesteuert werden kann.

Das Funktionsprinzip der erfindungsgemäß verwendeten Doppelbandpresse basiert darauf, daß auf die kontinuierlich durch die Presse bewegte Warenbahn ein über die Breite dieser Warenbahn gleichmäßiger und zeitlich konstanter Druck aufgebracht wird. Dies geschieht hier durch die Übertragung des Drucks von in der Presse befindlichen (nicht dargestellten) Druckkissen auf die endlosen Stahl-Druckbänder 8, die synchron mit der Warenbahn durch die Presse laufen und gleichzeitig als Finishgeber dienen. Vorzugsweise werden Druckbänder mit verhältnismäßig großer Masse, z.B. Stahlbänder von etwa 2 mm Dicke, verwendet, welche eine gute Wärmeübertragung gewährleisten.

Der Heizbereich 4 der Presse 1 weist eine Länge von z.B. 3 m auf. Der Abkühlbereich 5 weist eine Länge von 1 m in dargestellten, vorteilhaften Ausführungsbeispiel auf. Die Vorwärmzone 3 besitzt in diesem Fall vorzugsweise eine Länge von 40 bis 100 cm.

Vor der Doppelbandpresse sind Spindelabwickler 12, 13 mit je zwei Spindeln 14―17 für Prepregs, d.h. mit dem Harz-System versehene Glasfasergewebe und ein weiterer Spindelabwickler 18 mit zwei Spindeln 19, 21 für Kupferfolien angeordnet. Zwischen dem Spindelabwickler 18 und der Doppelbandpresse 1 sind Führungsrollen 22, 22' für die Metallfolien vorhanden.

In Produktionsrichtung hinter der Doppelbandpresse befindet sich eine Randbeschnitt-Vorrichtung 23 und anschließend eine Ablängvorrichtung 24.

Zur Beheizung der Vorwärmzone kann das seinerseits beheizbare Einzugs-Umlenktrommelpaar 6, 6', wie dies in der nachfolgenden Zeichnung in beispielhafter Form dargestellt ist herangezogen werden. Mittel zur Temperatursteuerung wie die Bleche 9, 9', können vorgesehen werden.

Die Doppelbandpresse kann in einer bevorzugten Ausführungsform Stützrollen 11, 11' für die Druckbänder aufweisen.

Mit Vorteil ist der druckwirksame Heizbereich in verschiedene unabhängig voneinander steuerbare Temperaturbereiche unterteilt.

Im Bereich der drucklosen Vorwärmzone sind, in einer bevorzugten Ausführungsform, räumlich gesteuerte Führungseinrichtungen vorgesehen, um die getrennte Zuführung der Glasfasergewebebahn und der Metallfolie zu unterstützen.

In Betrieb werden von den Spindelabwicklern 12, 13 vier Prepregbahnen, d.h. mit einem Epoxid-Härter-Beschleuniger-System versehene und bis zum forgeschrittenen B-Zustand vorgehärtete Glasfasergewebe abgezogen, zusammengebracht und der Vorwärmzone 3 zugeführt, wo das vierschichtige Gebilde, in Abhängigkeit vom Harz-System, auf eine Temperatur von etwa 80° bis 100°C drucklos erwärmt wird. Gleichzeitig werden von den zwei Spindeln 19, 21 des Spindelabwicklers 18 Kupferfolien geliefert, welche von den Prepregs getrennt zwischen dem jeweiligen Hitzeschild 9 bzw. 9' und dem Druckband 8 bzw. 8' geführt und unmittelbar vor der druckwirksamen Zone 2 mit den Prepregs zusammengeführt werden. Währenddem die Temperatur in der Vorwärmzone wie angegeben bis zu 100°C beträgt, liegt jene der Einzugstrommel höher, so daß die Kupferfolie stärker als die Prepregs erwärmt wird. In den drei Temperaturbereichen 41, 42, 43 des Heizbereiches 4 der druckwirksamen Zone 2 werden die zusammengeführeten Einzelschichten bei einem Druck von über 25 bar bei einer von 150° bis etwa 190°C ansteigenden Temperatur zur Basismaterialbahn verpreßt und durch Aushärten des noch reaktionsfähigen Harzes verbunden. Die Temperatur des ersten Temperaturbereiches 41 ist niedriger als jene des zweiten 42, die jenem des dritten 43 gleich sein kann und 190° bis 200°C beträgt. Im nachfolgenden Kühlbereich 5 wird die Basismaterialbahn unter Druck abgekühlt. In diesem heiklen Stadium verhindert die Druckanwendung eine Qualitätsverminderung, insbesondere Deformation des Produktes. Die Basismaterialbahn verläßt nun, auf etwa 100°C abgekühlt, den Kühlbereich 5. In der nachfolgenden Randbeschnitt-Vorrichtung 23 werden die Pressränder an den beiden Seiten der Basismaterialbahn entfernt, worauf sie in der Ablängvorrichtung 24 auf eine gewünschte Länge zugeschnitten wird.

Zwischen Kühlzone und Randbeschnitt-Vorrichtung kann eine Nachtemperierzone für die Formstabilisierung des Basismaterials angeordnet sein.

Vorteilhaft wird in der dargestellten Vorrichtung mit einer solchen Verweilzeit im Heizbereich 4 gearbeitet, welche einer Vorschubgeschwindigkeit innerhalb der Doppelbandpresse von ca. 3 m/Min. entspricht. Verweilzeit bzw. Vorschubgeschwindigkeit sind abhängig von der Aushärtetemperatur und der Reaktionsgeschwindigkeit des verwendeten Expoxidharz-Härter-Beschleunigungssystems.

Wenn nur einseitig kaschiertes Basismaterial hergestellt wird, kann anstelle der Kupferfolie eine hitzebeständige Trennfolie auf die entsprechende Spindel aufgewickelt vorliegen und in die Doppelbandpresse einlaufen. Als Trennfolie kann z.B. eine silikonisierte oder mit Polytetrafluoräthylen kaschierte Aluminiumfolie verwendet werden. Die Trennfolie kann nach dem Auslaufen aus der Doppelwandpresse von der fertigen Basismaterialbahn abgezogen und erneut verwendet werden.

Obwohl das erfindungsgemässe Verfahren anhand eines 6-schichtigen Basismaterials veranschaulicht worden ist, können selbstverständlich auch solche mit einer anderen Schichtenzahl hergestellt werden.

Die geschilderten Betriebsbedingungen sind in erster Linie vom verwendeten Harz-System abhängig und können entsprechend variiert werden.

Das erfindungsgemässe Verfahren bzw. die erfindungsgemässe Vorrichtung können nicht nur zum Kaschieren mit Kupfer, sondern auch mit anderen Metallfolien angewendet werden. Insbesondere eignen sie sich zum Kaschieren mit Kombinationsfolien, z.B. CU/Al, wie sie für Feinstleiterplatten (sogen. etchible/stripable Platten) eingesetzt werden.

Die Erfindung wird anhand der nachfolgenden Beispiele weiter veranschaulicht:

### Beispiel 1

Ein Glasgewebe in gefinishter Ausführung, wie es üblicherweise bei kupferkaschierten Glasfaser-Epoxidharz-Laminaten für Leiterplatten verwendet wird, mit einem Gewicht von 200 g/m² wurde mit einer Harzlösung, bestehend aus 100 Teilen eines polymeren, teilbromierten Bisphenol-A-Glycidyläthers mit einem Anteil epoxidierten Novolackes von 1 bis 15%, vorzugsweise von 5 bis 12%, 3,2 Teilen Dicyandiamid, 0,28 Teilen 3-Methylpyridin und 80 Teilen Methylglykol getränkt. Das so getränkte und bei 165°C getrocknete Prepreg hatte einen Harzgehalt von 42% und einen Harzfluss von 10%. Sieben dieser Prepregs wurden nach Vorwärmen auf 80°C bei einer von 150° auf 195°C ansteigenden Temperatur unter einem Druck von 45 bar auf der erfindungsgemässen Vorrichtung mit doppelseitiger 35 µm dicker Kupferfolienauflage zu einem 1,5 mm starken Laminat kontinuierlich durchlaufend verpresst. Die Prüfung des Laminates ergab überraschenderweise über dem Durchschnitt liegende positive Resultate in der Dimensionsstabilität bei sonst mit handelsüblichen Laminaten gleichwertigen Eigenschaften.

Das erhaltene Laminat weist eine Dickentoleranz von ±3/100 mm auf. Vergleichsweise sehen die Normen für starre Laminate eine Toleranz von ±13/100 mm vor, die von Produkten aus der Etagepresse auch voll ausgenützt wird.

### Beispiel 2

Ein Glasgewebe, wie in Beispiel 1 aufgeführt, wurde mit einer Harzlösung, bestehend aus 100 Teilen eines polymeren, teilbromierten Bisphenol-A-Glycidyläthers mit einem Anteil epoxidierten Novolackes von 1 bis 15%, vorzugsweise von 5 bis 12%, 3,4 Teilen Dicyandiamid, 0,33 Teilen 4-Dimethylaminopyridin und 80 Teilen Methylglykol getränkt. Das so getränkte und bei 170°C getrocknete Prepreg hatte einen Harzgehalt von 44% und einen Harzfluss von 8%. Mehrere dieser Prepregs wurden nach Vorwärmen auf 85°C mit doppelseitiger 35 µm Kupferfolienauflage bei einer von 155° bis 200°C ansteigenden Temperatur unter einem Druck von 50 bar auf der erfindungsgemässen vorrichtung zu einem 1,5 mm starken Laminat kontinuierlich durchlaufend verpresst. Die Prüfung des Laminates ergab auch in dieser Ausführung über der Norm liegende Werte in der Dimensionsstabilität bei sonst vergleichbaren Laminateigenschaften zu handelsüblichen Produkten.

### Beispiel 3

Mit einer Harzmischung, bestehend aus 100 Teilen eines polymeren, teilbromierten Bisphenol-A-Glycidyläthers mit einem Anteil epoxidierten Novolackes von 1 bis 15%, vorzugsweise von 5 bis 12% und mit einem Epoxid-Aequivalentgewicht zwischen 350 bis 520, 3,0 Teilen Dicyandiamid, 0,40 teilen 2-Amino-4-methylpyridin und 80 Teilen Methylglykol wurde ein 100 g/m² schweres Glasgewebe mit gleichem Verwendungszweck wie in Beispiel 1 dargelegt, getränkt und bei 165°C getrocknet. Der Harzgehalt betrug 44% und der Harzfluss 10%. Zwei dieser Prepregs wurden nach vorwärmen auf 80°C mit einseitiger 35 µm dicker Kupferfolienauflage unter Verwendung einer Trennfolie bei einer von 150° auf 190°C ansteigenden Temperatur unter einem Druck von 50 bar auf der erfindungsgemässen Vorrichtung zu einem 0,2 mm starken Laminat kontinuierlich durchlaufend verpresst. Die Prüfung ergab gleich gute Ergebnisse wie bei Beispiel 2.

### Beispiele 4 bis 13

Die Rezepturen bzw. Betriebsbedingungen der Beispiele 4 bis 13 sind in der nachfolgenden Tabelle zusammengestellt.

Sämtliche Prozente sind Gewichtsprozente.

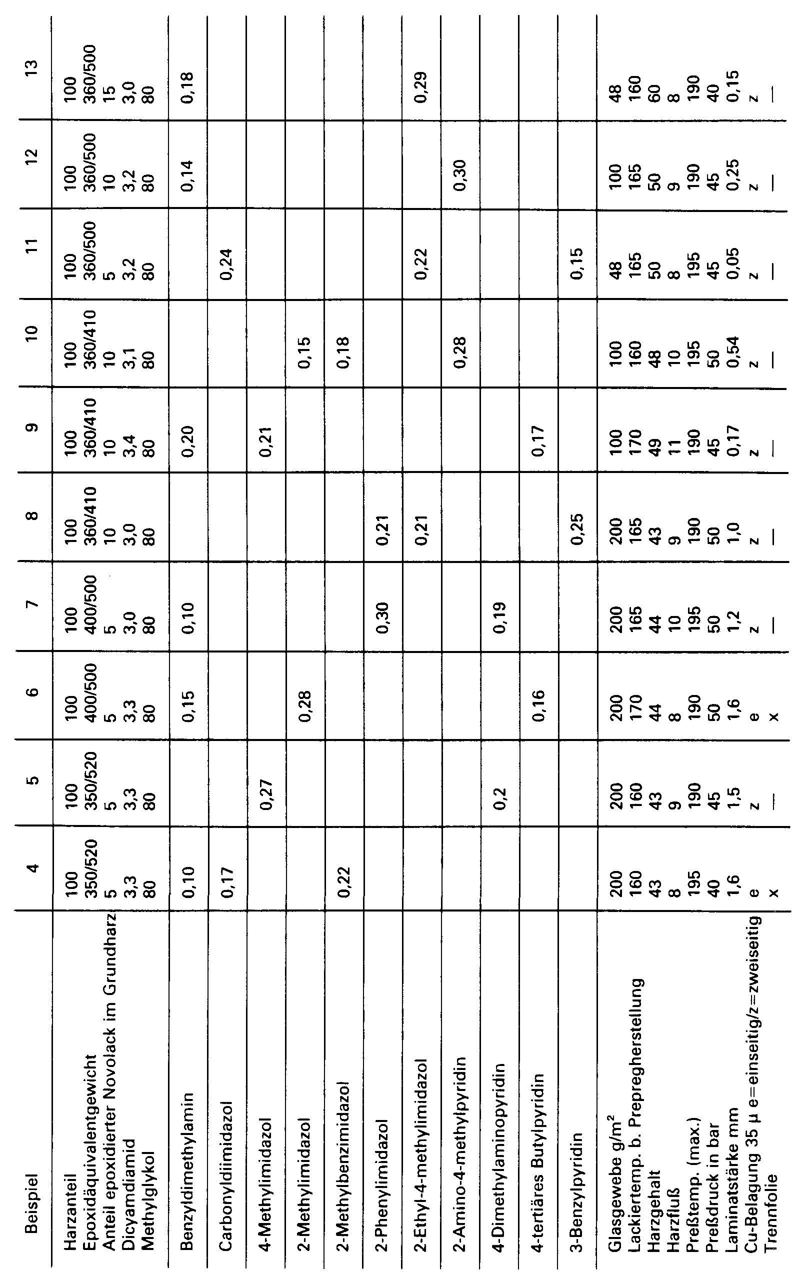

## Patentansprüche

1. Verfahren zum Herstellen von metallkaschiertem Basismaterial für Leiterplatten,
a) bei dem mit einem wärmehärtbarem Harz versehene Glasfasergewebebahnen und die aufzukaschierende Metallfolie (12) in einer Preßeinrichtung (1) unter Druck und Temperatur miteinander verpreßt werden,
b) bei dem das so erhaltene Basismaterial abgelängt wird, und
c) bei denen Glasfasergewebebahnen verwendet werden,
c1) die mit einem beschleunigten Harz-System imprägniert sind und
c2) deren Harz vorgehärtet ist;
**gekennzeichnet** durch die folgenden Merkmale:
d) die Glasfasergewebebahnen werden zusammengeführt und auf dem Weg zwischen im Abstand vergrößerten Einlauftrommeln (6, 6') bis zum Eintritt in die Druckzone (4) einer Doppelbandpresse (1) drucklos unter Viskositätsverringerung des Harz-Systems vorgewärmt; und
e) die drucklos vorgewärmten Glasfasergewebebahnen werden mit der (den) Metallfolie(n) zusammengeführt und in der Druckzone der Doppelbandpresse (1) bei Temperaturen von 150° bis 210°C zu der Basismaterialbahn verpreßt.

2. Verfahren nach Anspruch 1, dadurch gekennzeichnet, daß die Glasfasergewebebahn und die Metallfolien mit einem Druck von 25 bis 80 bar verpreßt werden.

3. Verfahren nach einem der Ansprüche 1 oder 2, dadurch gekennzeichnet, daß die beim Verpressen erhaltene Basismaterialbahn in einem, vorzugsweise innerhalb der Doppelbandpresse (1) angeordneten, Kühlbereich (5) unter Druckabgekühlt wird.

4. Verfahren nach einem der vorhergehenden Ansprüche, dadurch gekennzeichnet, daß das Basismaterial nachgetempert wird.

5. Verfahren nach einem der vorhergehenden Ansprüche, dadurch gekennzeichnet, daß bei der Herstellung von einseitig mit der Metallfolie kaschiertem Basismaterial auf der anderen Seite eine Trennfolie mit eingeführt und verpreßt wird, und daß die Trennfolie nach dem Auslaufen aus der Doppelbandpresse (1) von der Basismaterialbahn abgezogen wird.

6. Verfahren nach einem der vorhergehenden Ansprüche, dadurch gekennzeichnet daß die Glasfasergewebebahnen und die bzw. jede Metallfolie getrennt vorgewärmt werden.

7. Verfahren nach Anspruch 6, dadurch gekennzeichnet, daß die bzw. jede Metallfolie auf eine höhere Temperatur als die Glasfasergewebebahnen vorgewärmt wird.

8. Verfahren nach einem der vorhergehenden Ansprüche, dadurch gekennzeichnet, daß die Glasfasergewebebahnen erst unmittelbar vor der Druckzone der Doppelbandpresse (1) mit der bzw. jeder Metallfolie zusammengeführt werden.

9. Verfahren nach einem der vorhergehenden Ansprüche, dadurch gekennzeichnet, daß mit einem beschleunigten Epoxid-Härter-Katalysator-System imprägnierte und vorgehärtete Glasfasergewebebahnen verwendet werden.

10. Verfahren nach Anspruch 9, dadurch gekennzeichnet, daß ein Epoxid-Härter-Katalysator-System mit einem Beschleuniger verwendet wird, der mindestens eine Verbindung aus der folgenden Gruppe enthält: substituierte Pyridinverbindungen, Imidazol, und substituierte Imidazol-Verbindungen.

11. Verfahren nach Anspruch 10, dadurch gekennzeichnet, daß zusätzlich Dicyandiamid bzw. Benzyldimethylamin zugesetzt werden.

12. Verfahren nach einem der Ansprüche 10 oder 11, dadurch gekennzeichnet, daß 0,2 bis 0,8 Gew.-% des Beschleunigers bzw. der Beschleunigermischung, bezogen auf das Epoxid-Festharz, verwendet werden.

13. Beheizbare Doppelbandpresse (1) zur Durchführung des Verfahrens nach einem der Ansprüche 1 bis 12,
mit einem zwischen einem Einlauftrommelpaar (6, 6') und einem Auslauftrommelpaar (7, 7') angeordneten, druckwirksamen Heizbereich (4) zum Verpressen der Glasfasergewebebahnen und der Metallfolien zwischen zwei umlaufenden Druckbändern (8, 8')
wobei jedes der beiden Druckbänder (8, 8') eine Einlauftrommel und eine Auslauftrommel umschlingt,
**gekennzeichnet** durch eine drucklose Vorwärmzone (3) für die zusammengeführten Glasfasergewebebahnen im Bereich zwischen den im Abstand vergrößerten Einlauftrommeln (6, 6') und dem druckwirksamen Heizbereich (4), und
räumlich getrennte Führungseinrichtungen (12, 13, 18) zur räumlich getrennten Führung von Glasfasergewebebahnen und Metallfolie(n) in der Vorwärmzone (3).

14. Doppelbandpresse nach Anspruch 13, dadurch gekennzeichnet, daß die Vorwärmzone (3) ein Hitzeschildpaar (9, 9') mit steuerbarer Kühlung aufweist.

15. Doppelbandpresse nach Anspruch 14, dadurch gekennzeichnet, daß die beiden Hitzeschilder (9, 9') in horizontaler Richtung verschiebbar angeordnet sind.

16. Doppelbandpresse nach einem der Ansprüche 12 bis 15, dadurch **gekennzeichnet,** daß im Anschluß an das Einlauftrommelpaar (6, 6') Stützrollen (11, 11') für die Druckbänder (8, 8') vorgesehen sind.

17. Doppelbandpresse nach einem der Ansprüche 13 bis 16, dadurch gekennzeichnet, daß sich an den druckwirksamen Heizbereich (4) ein ebenfalls druckwirksamer Kühlbereich (5) anschließt.

18. Doppelbandpresse nach einem der Ansprüche 13 bis 17, dadurch gekennzeichnet, daß der druckwirksame Heizbereich (4) in voneinander unabhängig steuerbare Temperaturbereiche (41, 42, 43) unterteilt ist.

## Claims

1. A process for the production of metal-clad base material for printed circuit boards,
a) wherein glass fibre cloth webs provided with a thermosetting resin and the metal foil (12) to be applied thereto to form the cladding are pressed together in a pressing apparatus (1), under pressure and at a temperature, and
b) wherein the base material produced in that way is cut to length, and
c) in which glass fibre cloth webs are used
c1) which are impregnated with an accelerated resin system and
c2) the resin of which is prehardened;
characterised by the following features:
d) the glass fibre cloth webs are brought together and preheated in a pressure-less condition with a reduction in the viscosity of the resin system on the path between intake drums (6, 6') which are increased in spacing to the entry into the pressure zone (4) of a double-belt press (1); and
e) the glass fibre cloth webs which are preheated in a pressure-less condition are brought together with the metal foil or foils and pressed in the pressure zone of the double-belt press (1) at temperatures of 150°C to 210°C, to provide the base material web.

2. A process according to claim 1 characterised in that the glass fibre cloth web and the metal foils are pressed at a pressure of from 25 to 80 bars.

3. A process according to one of claims 1 and 2 characterised in that the base material web which is obtained in the pressing operation is cooled under pressure in a cooling region (5) which is preferably disposed within the double-belt press (1).

4. A process according to one of the preceding claims characterised in that the base material is post-tempered.

5. A process according to one of the preceding claims characterised in that, in the production of base material which is clad with the metal foil on one side, a separating foil is also introduced and pressed on the other side, and that the separating foil is removed from the base material web after issuing from the double-belt press (1).

6. A process according to one of the preceding claims characterised in that the glass fibre cloth webs and the or each metal foil are preheated separately.

7. A process according to claim 6 characterised in that the or each metal foil is preheated to a higher temperature than the glass fibre cloth webs.

8. A process according to one of the preceding claims characterised in that the glass fibre cloth webs are only brought together with the or each metal foil immediately upstream of the pressure zone of the double-belt press (1).

9. A process according to one of the preceding claims characterised by using glass fibre cloth webs which are impregnated with an accelerated epoxy-hardener-catalyst system and prehardened.

10. A process according to claim 9 characterised by using an epoxy-hardener-catalyst system with an accelerator which includes at least one compound from the following group: substituted pyridine compounds, imidazole and substituted imidazole compounds.

11. A process according to claim 10 characterised in that dicyanodiamide or benzyldimethylamine are additionally added.

12. A process according to one of claims 10 and 11 characterised by using from 0.2 to 0.8% by weight of the accelerator or the accelerator mix, with respect to the hard epoxy resin.

13. A heatable double-belt press (1) for carrying out the process according to one of claims 1 to 12
comprising a pressure-applying heating region (4) between a pair of intake drums (6, 6') and a pair of discharge drums (7, 7') for pressing the glass fibre cloth webs and the metal foils between two circulating pressure belts (8, 8'),
wherein each of the two pressure belts (8, 8') passes around an intake drum and a discharge drum,
characterised by
a pressure-less preheating zone (3) for the glass fibre cloth webs which have been brought together in the region between the intake drums (6, 6') which are increased in spacing and the pressure-applying heating region (4), and
spatially separated guide means (12, 13, 18) for the spatially separated guidance of the glass fibre cloth webs and metal foil or foils in the preheating zone (3).

14. A double-belt press according to claim 13 characterised in that the preheating zone (3) has a pair of heat plates (9, 9') with controllable cooling.

15. A double-belt press according to claim 14 characterised in that the two heat plates (9, 9') are arranged to be displaceable in the horizontal direction.

16. A double-belt press according to one of claims 13 to 15 characterised in that support rollers (11, 11') for the pressure belts (8, 8') are provided subsequently to the pair of intake drums (6, 6').

17. A double-belt press according to one of claims 13 to 16 characterised in that a cooling region (5) which also applies a pressure follows the pressure-applying heating region (4).

18. A double-belt press according to one of claims 13 to 17 characterised in that the pressure-applying heating region (4) is subdivided into temperature regions (41, 42, 43) which can be controlled independently of each other.

## Revendications

1. Procédé de fabrication d'un matériau de base, revêtu de cuivre, pour des plaquettes à circuits imprimés, qui consiste,
a) à assembler, sous pression et à une certaine température, des bandes de tissu de fibres de verre munies d'une résine thermodurcissable et la feuille (12) métallique à appliquer en revêtement, dans un dispositif de presse (1),
b) à tronçonner le matériau de base ainsi obtenu, et
c) à utiliser des bandes de tissu de fibres de verre,
c1) qui sont imprégnées d'un système de résine accéléré ; et
c2) dont la résine est prédurcie ;
remarquable par les caractéristiques suivantes:
d) on réunit les bandes de tissu de fibres de verre et on les préchauffe sans pression avec diminution de la viscosité du système de résine sur le trajet entre des tambours (6,6') d'introduction distants l'un de l'autre d'une assez grande distance jusqu'à l'entrée dans la région (4) de compression d'une presse (1) à bande double; et
e) on réunit les bandes de tissu de fibres de verre préchauffées sans pression à la feuille métallique ou aux feuilles métalliques et on les comprime, dans la région de compression de la presse à double bande (1), à une température comprise entre 150° et 210°C en la bande de matériau de base.

2. Procédé suivant la revendication 1, caractérisé en ce qu'il consiste à comprimer la bande de tissu de fibres de verre et les feuilles métalliques sous une pression de 25 à 80 bar.

3. Procédé suivant l'une des revendications 1 ou 2, caractérisé en ce qu'il consiste à refroidir sous pression la bande de matériau de base obtenue par la compression, dans une région de refroidissement (5), disposée de préférence à l'intérieur de la presse à double bande (1).

4. Procédé suivant l'une des revendications précédentes, caractérisé en ce qu'il consiste à équilibrer ultérieurement la température du matériau de base.

5. Procédé suivant l'une des revendications précédentes, caractérisé en ce que, pour la fabrication de matériau de base revêtu de la feuille métallique sur une seule face, on introduit et on applique sous pression sur l'autre face une pellicule de séparation et on retire la pellicule de séparation de la bande de matériau de base après la sortie de la presse à double bande (1).

6. Procédé suivant l'une des revendications précédentes, caractérisé en ce qu'il consiste à préchauffer les bandes de tissu de fibres de verre et la ou chaque feuille métallique indépendamment.

7. Procédé suivant la revendication 6, caractérisé en ce qu'il consiste à préchauffer la ou chaque feuille métallique à une température plus élevée que celles des bandes de tissu de fibres de verre.

8. Procédé suivant l'une des revendications précédentes, caractérisé en ce qu'il consiste à réunir les bandes de tissu de fibres de verre à la feuille métallique ou à chaque feuille métallique, juste en amont de la zone de compression de la presse à double bande (1).

9. Procédé suivant l'une des revendications précédentes, caractérisé en ce qu'il consiste à utiliser des bandes de tissu de fibres de verre imprégnées d'un système époxy-durcisseur-catalyseur accéléré et prédurci.

10. Procédé suivant la revendication 9, caractérisé en ce qu'il consiste à utiliser un système époxyde-durcisseur-catalyseur avec un accélérateur qui contient au moins un composé appartenant aux groupes suivants : composés de pyridine substitué, imidazole et composés d'imidazole substitués.

11. Procédé suivant la revendication 10, caractérisé en ce qu'il consiste à ajouter, en outre, du dicyandiamide ou de la benzyldiméthylamine.

12. Procédé suivant l'une des revendications 10 ou 11, caractérisé en ce qu'il consiste à utiliser de 0,2 à 0,8 % en poids de l'accélérateur ou du mélange d'accélérateurs, rapporté à la résine solide époxyde.

13. Presse (1) à bande double pouvant être chauffée, pour la mise en oeuvre du procédé suivant l'une des revendications 1 à 12, comprenant :
une région de chauffage (4), qui est disposée entre une paire de tambours (6,6') d'introduction et une paire de tambours (7,7') d'extraction, dans laquelle la pression est appliquée et qui est destinée à comprimer les bandes de tissu de fibres de verre et les feuilles métalliques entre deux bandes (8,8') de pression
chacune des deux bandes (8,8') de pression passant autour d'un tambour d'introduction et d'un tambour d'extraction, caractérisée par
une zone de préchauffage (3) sans pression, destinée à préchauffer les bandes de tissu de fibres de verre réunies dans la région comprise entre les tambours (6,6') d'introduction distants entre eux d'une assez grande distance et la région de chauffage (4) où s'applique la pression, et
dans la région de la zone de préchauffage (3), des dispositifs de guidage (12, 13 , 18), séparés dans l'espace, pour guider séparément dans l'espace les bandes de tissu de fibres de verre et la ou les feuille(s) métallique(s).

14. Presse à double bande suivant la revendication 13, caractérisée en ce que la zone de préchauffage (3) comporte un couple de boucliers thermiques (9, 9') à refroidissement pouvant être réglé.

15. Presse à bande double suivant la revendication 14, caractérisée en ce que les deux boucliers thermiques (9, 9') peuvent être déplacés dans la direction horizontale.

16. Presse à bande double suivant l'une des revendications 12 à 15, caractérisée en ce qu'à la suite du couple de tambours (6,6') d'introduction sont prévus des rouleaux d'appui (11, 11') pour les bandes de pression (8, 8').

17. Presse à bande double suivant l'une des revendications 13 à 16, caractérisée en ce qu'à la région de chauffage (4), dans laquelle s'applique la pression, fait suite une région de refroidissement (5), dans laquelle s'applique également la pression.

18. Presse à bande double suivant l'une des revendications 13 à 17, caractérisée en ce que la région de chauffage (4), dans laquelle s'applique la pression, est subdivisée en domaines de température (41, 42, 43) qui peuvent être réglés indépendamment les uns des autres.
